Europäisches Patentamt

(19) European Patent Office  (11) Publication number: **0 015 070**

Office européen des brevets  **B1**

(12) **EUROPEAN PATENT SPECIFICATION**

(45) Date of publication of patent specification: **19.06.85**  (51) Int. Cl.⁴: **G 11 C 7/06, H 03 K 5/02**

(21) Application number: **80300235.1**

(22) Date of filing: **24.01.80**

(54) **Sense amplifier circuit.**

(30) Priority: **07.02.79 JP 13061/79**

(43) Date of publication of application:
**03.09.80 Bulletin 80/18**

(45) Publication of the grant of the patent:
**19.06.85 Bulletin 85/25**

(84) Designated Contracting States:
**DE FR GB NL**

(56) References cited:
**US-A-3 882 409**
**US-A-4 079 332**
**US-A-4 136 292**

**NACHRICHTENTECHNIK-ELEKTROTECHNIK,
vol. 28, no. 7, 1978, Berlin, W.J. FISCHER
"Technologie und Schaltungstechnik statischer
MOS-Speicher", pages 279 to 283**
**IBM TECHNICAL DISCLOSURE BULLETIN, vol.
15, no. 6, november 1972, New York, E.C.
JACOBSOM et al. "Sense amplifier", pages
1732 to 1733**

(73) Proprietor: **FUJITSU LIMITED**
**1015, Kamikodanaka Nakahara-ku**
**Kawasaki-shi Kanagawa 211 (JP)**

(72) Inventor: **Yamauchi, Takahiko**
**40-4, Fujigaoka 2-chome**
**Midori-ku Yokohama-shi, Kanagawa 227 (JP)**

(74) Representative: **Allman, Peter John et al**
**Marks and Clerk Scottish Life House Bridge
Street**
**Manchester M3 3DP (GB)**

Courier Press, Leamington Spa, England.

## Description

The present invention relates to a sense amplifier circuit for detecting and amplifying two bipolar differential signals. The circuit serves as an interface between the memory portion and the logic portion of a computer.

In general, the voltages $V_{i1}$ and $V_{i2}$ of two bipolar differential signals can be represented as follows.

$$V_{i1}=V_c+V_d$$

$$V_{i2}=V_c-V_d$$

where $V_c$ is a common direct component of the two signals, and $V_d$ is a differential component of the two signals. In a memory such as an MOS (Metal Oxide Semiconductor) memory of a computer, the value of $V_d$ is, for example, about 0.5 volt (which value is called an MOS level), while, in a logic such as a TTL (Transistor Transistor Logic) inverter of the computer, the value of $V_d$ is about 1.5 volts (which value is called a TTL level). In general, the MOS level is very small compared with the TTL level, so that the signals of the MOS level cannot operate the TTL inverter. As a result, the memory is provided with a sense amplifier circuit for changing an MOS level of two bipolar differential signals to a TTL level thereof. Therefore, the sense amplifier circuit serves as an interface between the memory portion and the logic portion of the computer.

One prior art sense amplifier circuit comprises two or more differential amplifiers to each of which a reference transistor for producing the reference operating voltage of each of the differential amplifiers is connected. Each of the reference operating voltages is preset to be almost constant so that the difference in potential between the two bipolar differential signals can be amplified by the differential amplifiers. In the case of providing two differential amplifiers, the difference in potential between two bipolar differential signals is amplified by a first differential amplifier and, after that, the amplified difference in potential is amplified by a second differential amplifier whose output signals are applied to a logic such as a TTL inverter.

However, in the prior art sense amplifier circuit, the sensing speed is low, since the sensing operation is effected by a two or more stage amplification and the change of the conductances of input transistors forming the differential amplifiers is not small due to the constant of the reference voltages. In addition, the sensing operation is unstable, since the constant reference voltages are changed responsive to the change of a power supply voltage. At worst, it may happen that the sensing operation is not effected.

A second prior art sense amplifier comprises a differential amplifier and a reference transistor for producing a reference operating voltage for the differential amplifier (see United States Patent No. 4 079 332). The reference transistor is controlled by an output signal of the differential amplifier, so that the reference voltage is variable in response to the input signals. As a result, the conductances of input transistors are forced to be large, that is, the input transistors rapidly conduct. Therefore, the sensing speed becomes higher as compared with the above prior art circuit having two differential amplifiers. In addition, the sensing operation becomes stable, since the voltage applied to the gate of one of the input transistors and the reference voltage thereof are changed in opposite directions, so that the input transistors can be easily operated.

However, in the second prior art sense amplifier circuit, the difference in potential between the two bipolar output signals is relatively small, which may fail to operate a TTL inverter or the like.

It is an object of the present invention to provide a sense amplifier circuit capable of producing two bipolar signals, the difference in potential between which is large, while maintaining a stable and high-speed sensing operation.

According to the present invention, there is provided a sense amplifer circuit comprising first and second differential amplifiers each of which consists of first and second input transistors, each input transistor being connected in series with a load transistor which is connected to a first power supply line, and a reference transistor connected between the first and second input transistors and a second power supply line, the phases of first and second input signals applied to the input transistors being mutually complementary, characterised in that the first input signal is connected to the gate electrodes of the first input transistors of the first and second differential amplifiers and the second input signal is connected to the gate electrodes of the second input transistors of the first and second differential amplifiers, and the reference transistor of the first differential amplifier is controlled either by the first input signal or a first output signal provided by the second differential amplifier which is in phase with the first input signal, and the reference transistor of the second differential amplifier is controlled either by the second input signal or a first output signal provided by the first differential amplifier which is in phase with the second input signal.

A third reference transistor may be connected in parallel to the reference transistor of the first differential amplifier and controlled either by the first input signal or by the second output signal of the first differential amplifier the phase of which is inverse to that of the first output signal of the first differential amplifier.

A fourth reference transistor may be connected in parallel to the reference transistor of the second differential amplifier and controlled either by the second input signal or by the second output signal of the second differential amplifier the phase of which is inverse to that of the first output signal of the second differential amplifier.

The present invention will be more clearly understood from the following description with reference to the accompanying drawings wherein:

Fig. 1 is a block circuit diagram illustrating a general static memory including a sense amplifier circuit;

Fig. 2 is a circuit diagram illustrating a memory cell in the memory of Fig. 1;

Fig. 3 is a circuit diagram illustrating one prior art sense amplifier circuit;

Fig. 4 is a timing diagram showing the signals appearing in the sense amplifier circuit of Fig. 3;

Fig. 5 is a circuit diagram illustrating another prior art sense amplifier circuit,

Fig. 6 is a timing diagram showing the signals appearing in the sense amplifier circuit of Fig. 5;

Fig. 7 is a circuit diagram illustrating an alternative prior art sense amplifier circuit to that of Fig. 5,

Fig. 8 is a circuit diagram illustrating a first embodiment of the sense amplifier circuit of the present invention;

Fig. 9 is a timing diagram showing the signals appearing in the sense amplifier circuit of Fig. 8, and;

Fig. 10, 11A, 11B and 12 are circuit diagrams illustrating second, third, fourth and fifth embodiments of the sense amplifier circuit of the present invention, respectively.

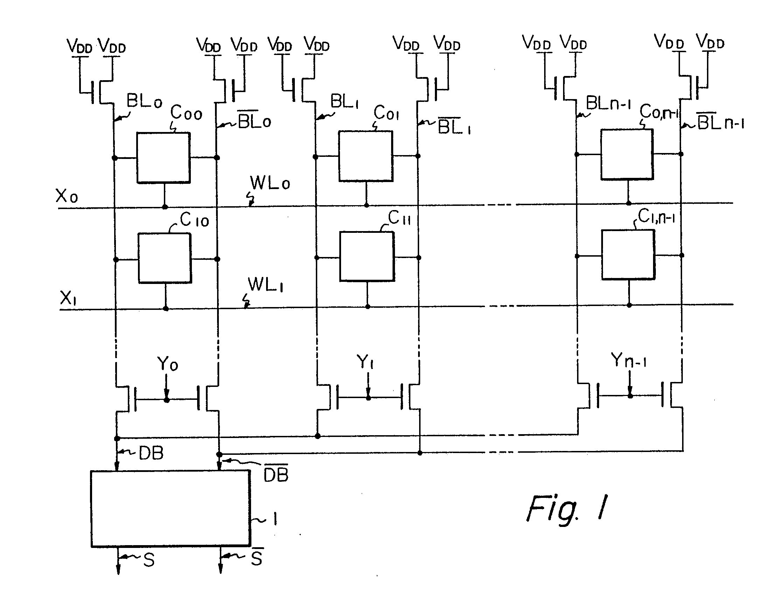

In Fig. 1, the memory such as a static MOS memory comprises a cell array composed of memory cells (n rows ×n columns). For example, when a memory cell $C_{11}$ in the first row of the first column is selected, the potential of a row address signal $X_1$ is changed from low to high by a row decoder (not shown) and, accordingly, the potential at a word line $WL_1$ is changed from low to high. In addition, the potential of a column signal $Y_1$ is changed from low to high by a column decoder (not shown) and, accordingly, bit lines $BL_1$ and $\overline{BL_1}$ are connected to data bit lines DB and $\overline{DB}$, respectively. As a result, two different voltages at the data bit lines DB and $\overline{DB}$ whose difference is at an MOS level are applied to a sense amplifier circuit 1 so that the sense amplifier circuit 1 produces signals S and $\overline{S}$ whose difference in potential is at a TTL level.

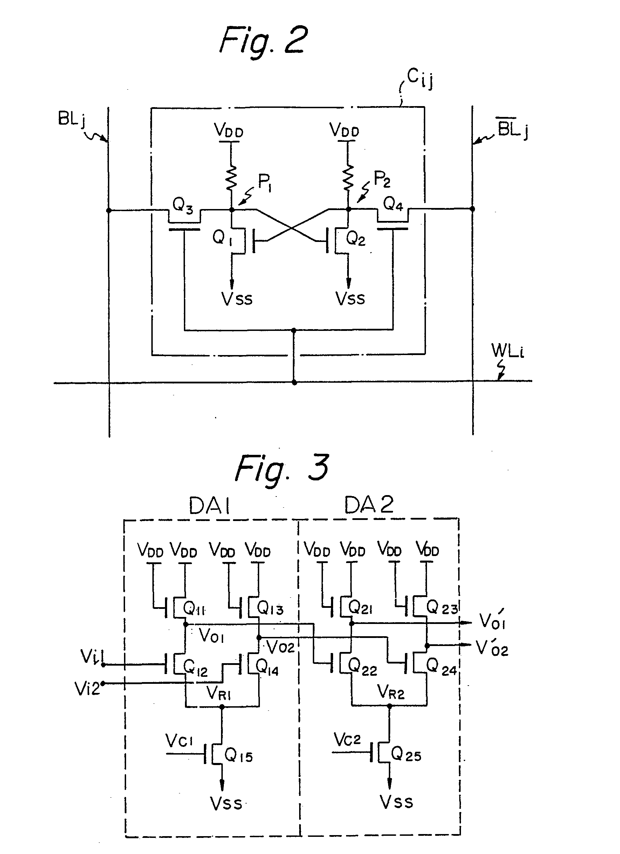

Fig. 2 is a circuit diagram illustrating a memory cell in the memory of Fig. 1. In Fig. 2, the logic "1" state of the memory cell $C_{ij}$ corresponds to the state wherein the potentials at $P_1$ and $P_2$ are low and high, respectively, i.e., that an MOS transistor $Q_1$ is conductive and a MOS transistor $Q_2$ is non-conductive. Similarly, the logic "0" state of the memory cell $C_{ij}$ corresponds to the state wherein the potentials at $P_1$ and $P_2$ are high and low, respectively, i.e., that the transistor $Q_1$ is non-conductive and the transistor $Q_2$ is conductive. The read-out operation of the memory cell $C_{ij}$ is carried out by the signals $X_i$ and $Y_j$ (not shown) whose potentials are high. As a result, the MOS transistors $Q_3$ and $Q_4$ are

conductive, so that the signals representing the logic "1" or "0" appearing in the bit lines $BL_j$, and $\overline{BL_j}$, are transmitted through the data bit lines DB and $\overline{DB}$ to the sense amplifier circuit 1 (Fig. 1). Thus, the logic "1" or "0" is read out by means of the sense amplifier circuit 1.

Fig. 3 is a circuit diagram illustrating one prior are sense amplifier circuit. The sense amplifier circuit comprises two differential amplifiers and two reference MOS transistors $Q_{15}$ and $Q_{25}$ for determining the reference voltages of the differential amplifiers. The first one of the differential amplifiers is composed of two load MOS transistors $Q_{11}$ and $Q_{13}$ whose drains and gates are connected, respectively, and two input MOS transistors $Q_{12}$ and $Q_{14}$, while the second one is composed of two load MOS transistors $Q_{21}$ and $Q_{22}$ whose drains and gates are connected, respectively, and two input MOS transistors $Q_{23}$ and $Q_{24}$. The voltages $V_{C1}$ and $V_{C2}$ are preset to be constant so that the reference voltages $V_{R1}$ and $V_{R2}$ are almost constant. In this case, the voltage $V_{C1}$ is lower than the voltage $V_{C2}$ so that the reference voltage $V_{R1}$ is higher than the reference voltage $V_{R2}$. Two voltages $V'_{01}$ and $V'_{02}$ which are outputted from the second differential amplifier serve as output voltages of the sense amplifier circuit.

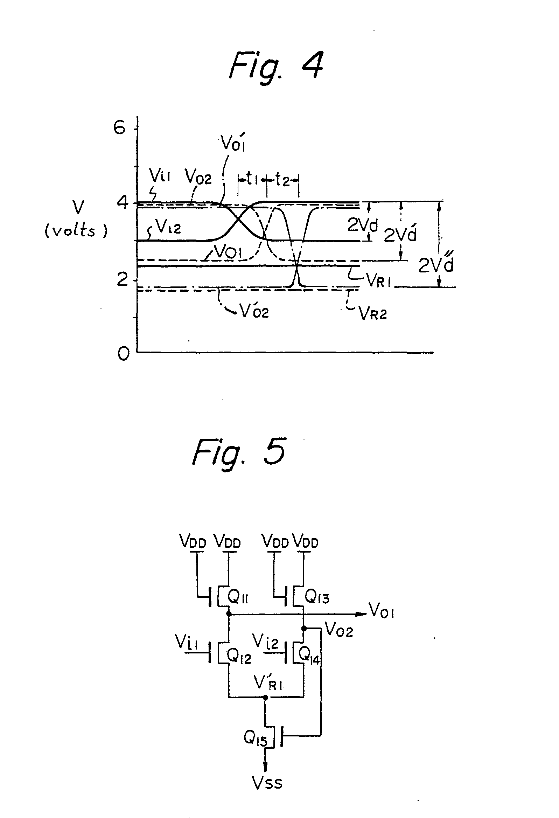

The operation of the sense amplifier circuit of Fig. 3 will be explained below. All the MOS transistors used in Fig. 3 are, for example, n-channel MOS transistors whose threshold voltage $V_{th}$ is, for example, about 0.7 volt. The power supply voltages $V_{DD}$ and $V_{SS}$ are, for example, 5 volts and 0 volt, respectively. Fig. 4 is a timing diagram showing the signals appearing in the sense amplifier circuit of Fig. 3. As illustrated in Fig. 4, the voltages $V_{R1}$ and $V_{R2}$ are constant. When the input voltages $V_{I1}$ and $V_{I2}$ whose values are, for example, 4 volts and 3 volts, respectively, are applied to the MOS transistors $Q_{12}$ and $Q_{14}$, respectively, the MOS transistor $Q_{12}$ conducts and the MOS transistor $Q_{14}$ remains non-conductive. In this case, the input voltages $V_{I1}$ and $V_{I2}$ have to satisfy the following inequalities.

$$V_{I1} > V_{R1} + V_{th} \qquad (1)$$

$$V_{I2} < V_{R1} + V_{th} \qquad (2)$$

As a result, the voltage $V_{01}$ becomes at about 2.5 volts and the voltage $V_{02}$ remains at about 4 volts. The voltages $V_{01}$ and $V_{02}$ have to satisfy the following inequalities.

$$V_{01} < V_{R2} + V_{th} \qquad (3)$$

$$V_{02} > V_{R2} + V_{th} \qquad (4)$$

The voltages $V_{01}$ and $V_{02}$ are applied to the MOS transistors $Q_{22}$ and $Q_{24}$ of the second differential amplifier which serves as an inverter, so that the differential amplifier produces two output voltages $V'_{01}$ and $V'_{02}$ whose values are about 4 volts and 1.8 volt, respectively. Thus, the difference $2V_d$ between the voltages $V_{i1}$ and $V_{i2}$ is amplified by the first differential amplifier and the difference $2V'_d$ between the voltages $V_{01}$ and $V_{02}$ is amplified by the second differential amplifier. As a result, the difference $2V''_d$ between the voltages $V'_{01}$ and $V'_{02}$ which is at a TTL level can be obtained.

When the input voltage $V_{i1}$ is changed from high to low and the input voltage $V_{i2}$ is changed from low to high as shown in Fig. 4, the MOS transistor $Q_{12}$ cuts off and the MOS transistor $Q_{14}$ conducts so that the voltages $V_{01}$ and $V_{02}$ outputted from the first differential amplifier are changed. As a result, the MOS transistor $Q_{22}$ conducts and the MOS transistor $Q_{24}$ cuts off so that the voltages $V'_{01}$ and $V'_{02}$ outputted from the second differential amplifier are also changed. In this case, the input voltages $V_{i1}$ and $V_{i2}$ and the voltages $V_{01}$ and $V_{02}$ have to satisfy the following inequalities.

$$V_{i1} < V_{R1} + V_{th} \qquad (1)'$$

$$V_{i2} > V_{R1} + V_{th} \qquad (2)'$$

$$V_{01} > V_{R2} + V_{th} \qquad (3)'$$

$$V_{02} < V_{R2} + V_{th} \qquad (4)'$$

The sensing speed of the sense amplifier circuit of Fig. 3 can be represented by $1/(t_1 + t_2)$ wherein $t_1$ and $t_2$ are delay times of the first and second differential amplifiers, respectively. In addition, the value $1/t_1$ depends upon $\Delta V_1$ which equals $|V_{i1} - (V_{R1} + V_{th})|$ or $|V_{i2} - (V_{R2} + V_{th})|$, while the value $1/t_2$ depends upon $\Delta V_2$ which equals $|V_{01} - (V_{R2} + V_{th})|$ or $|V_{02} - (V_{R2} + V_{th})|$.

In the sense amplifier circuit of Fig. 3, the voltages $V_{R1}$ and $V_{R2}$ are almost constant so that the values $\Delta V_1$ and $\Delta V_2$ cannot be greater than a definite value, i.e., the values $1/t_1$ and $1/t_2$ cannot be greater than a definite value. In addition, the sensing operation can be performed by using two-stage amplification. As a result, the sensing speed by the circuit of Fig. 3 is low. Further, when the power supply voltage is changed, the reference voltages $V_{R1}$ and $V_{R2}$ are also changed, which enable the sensing operation to be unstable. Furthermore, at worst, it may happen that the voltages $V_{i1}$ and $V_{i2}$ do not satisfy the inequalities (1) and (2) (or (1)' and (2)') and the voltages $V_{01}$ and $V_{02}$ do not satisfy the inequalities (3) and (4) (or (3)' and (4)'), i.e., the sensing operation is not performed.

Fig. 5 is a circuit diagram illustrating another prior art sense amplifier circuit see U.S. Patent No. 4,079,332). The sense amplifier circuit of Fig. 5 is applied to the case wherein only one differential output signal is needed. The sense amplifier circuit comprises one differential amplifier formed by four MOS transistors $Q_{11}$, $Q_{12}$, $Q_{13}$ and $Q_{14}$ and a reference MOS transistor $Q_{15}$. One output voltage $V_{02}$ of the differential amplifier is feedback to the gate of the MOS transistor $Q_{15}$ so that the reference voltage $V'_{R1}$ is variable.

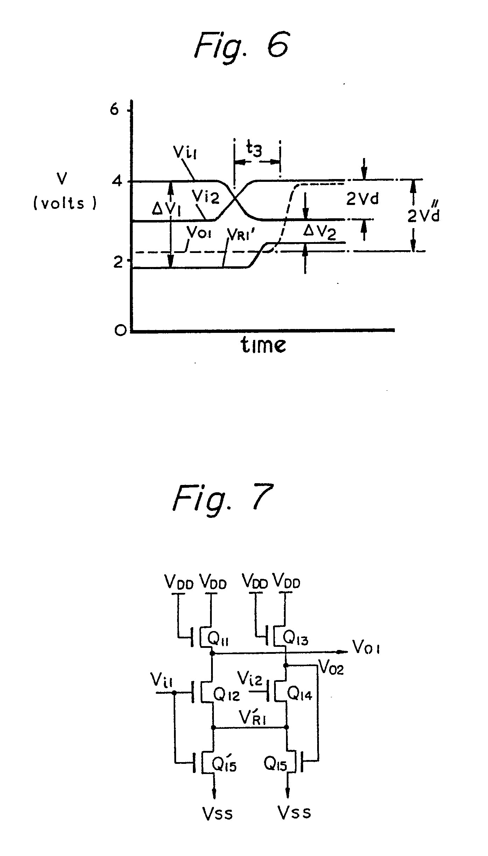

The operation of the sense amplifier circuit of Fig. 5 will be explained below. Fig. 6 is a timing diagram showing the signals appearing in the sense amplifier circuit of Fig. 5. Referring to Fig. 6, when the input voltages $V_{i1}$ and $V_{i2}$ whose values are, for example, 4 volts (high level) and 3 volts (low level), respectively, are applied to the MOS transistors $Q_{12}$ and $Q_{14}$, respectively, the voltage $V_{02}$ becomes higher than the voltage $V_{01}$. As a result, the conductance of the MOS transistor $Q_{15}$ becomes very large so that the reference voltage $V'_{R1}$ becomes low, which makes the conductance of the MOS transistor $Q_{12}$ to be very large. Therefore, the output voltage $V_{01}$ is very small. In this case, the MOS transistor $Q_{14}$ is also conductive, but the conductance of the MOS transistor $Q_{14}$ is smaller than that of the MOS transistor $Q_{12}$.

Next, when the input voltage $V_{i1}$ is changed from high to low and the input voltage $V_{i2}$ is changed from low to high, the conductance of the MOS transistor $Q_{14}$ becomes large so that the voltage $V_{02}$ is decreased. Therefore, the conductance of the MOS transistor $Q_{15}$ becomes small so that the reference voltage $V'_{R1}$ is increased as illustrated in Fig. 6. In this case, if the difference $\Delta V_2$ in potential between the input voltage $V_{i1}$ and the reference voltage $V'_{R1}$ is smaller than the threshold voltage $V_{th}$ whose value is, for example, 0.7 volt, the MOS transistor $Q_{12}$ cuts off so that the output voltage $V_{01}$ is rapidly increased. Thus, when the input voltage $V_{i1}$ is high, the difference $\Delta V_1$ in potential between the input voltage $V_{i1}$ and the reference voltage $V'_{R1}$ is much larger than $V_{th}$, and contrary to this, when the input voltage $V_{i1}$ is low, the difference $\Delta V_2$ in potential between the input voltage $V_{i1}$ and the reference voltage $V'_{R1}$ is smaller than $V_{th}$. As a result of this, a high sensing speed whose value corresponds to $1/t_3$ in Fig. 6 can be obtained. In addition, a stable sensing operation can be also obtained, since if the input voltage $V_{i1}$ is increased due to the increase of a power supply voltage, the input voltage $V_{i2}$ is also increased so that the output voltages $V_{01}$ and $V_{02}$ are decreased and the reference voltage $V'_{R1}$ is increased. However, in the circuit of Fig. 5, it should be noted that the difference of the voltage $V_{02}$ responsive to changes of the input voltages $V_{i1}$ and $V_{i2}$ is smaller than the difference of the voltage $V_{01}$ which is represented by $2V_d''$ in Fig. 6, since the transistor $Q_{14}$ is always conductive. Therefore, since the reference transistor $Q_{15}$ for determining the reference voltage $V_{R1}'$ is also controlled by the voltage $V_{02}$, the difference ($=2V_d''$) of the output voltage $V_{01}$ is relatively small. In addition, if the load transistors $Q_{11}$ and $Q_{13}$ are of a depletion type, it is difficult to set up the ratio of the values gm of each of the transistors for determining the potential level at each of the nodes.

Fig. 7 is a circuit diagram illustrating a prior art sense amplifier circuit which is an alternative to that of Fig. 5. The sense amplifier circuit of Fig. 7 further comprises a reference MOS transistor $Q'_{15}$, in addition to the sense amplifier circuit of Fig. 5. The gate of the MOS transistor $Q'_{15}$ receives the input voltage $V_{i1}$ so that the reference voltage $V'_{R1}$ can be also obtained as illustrated in Fig. 6. Therefore, the operation of the sense amplifier circuit of Fig. 7 is similar to that of the sense amplifier circuit of Fig. 5. However, the former operation (Fig. 7) is more reliable than the latter operation (Fig. 5).

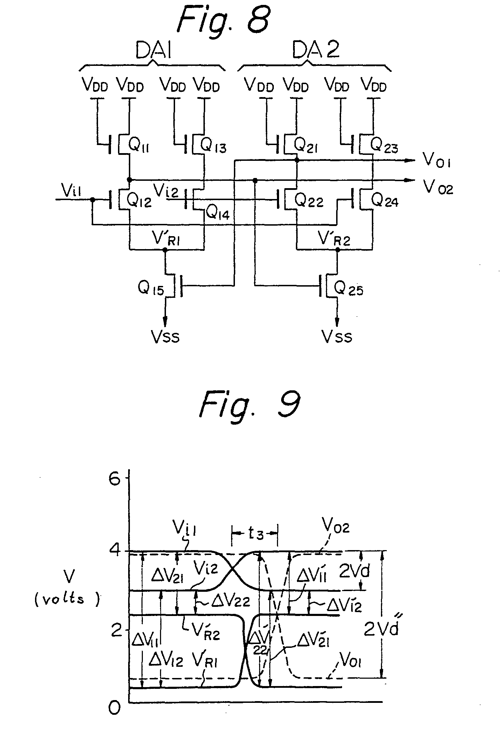

Fig. 8 is a circuit diagram illustrating a first embodiment of the sense amplifier circuit of the present invention. This sense amplifer circuit is applied to the case wherein two differential output signals are needed. The sense amplifier circuit comprises a first differential amplifier formed by four MOS transistors $Q_{11}$, $Q_{12}$, $Q_{13}$ and $Q_{14}$, a reference MOS transistor $Q_{15}$, a second differential amplifier formed by four MOS transistors $Q_{21}$, $Q_{22}$, $Q_{23}$ and $Q_{24}$ and a reference MOS transistor $Q_{25}$. The reference MOS transistor $Q_{15}$ is controlled by one output voltage $V_{01}$ of the second differential amplifier whose phase is the same as that of the first input voltage $V_{i1}$, while the reference MOS transistor $Q_{25}$ is controlled by one output voltage $V_{02}$ of the first differential amplifier whose phase is the same as that of the second input voltage $V_{i2}$. Though the sense amplifier circuit comprises two differential amplifiers, the differential amplifiers can operate simultaneously which means that the sensing operation can be performed by using one-stage amplification.

The operation of the sense amplifier circuit of Fig. 8 will be explained below. Fig. 9 is a timing diagram showing the signals appearing in the sense amplifier circuit of Fig. 8. Referring to Fig. 9, when the input voltage $V_{i1}$ and $V_{i2}$ whose values are, for example, 4 volts (high level) and 3 volts (low level), respectively, are applied to the MOS transistors $Q_{12}$, $Q_{24}$ and the MOS transistors $Q_{14}$ and $Q_{22}$, respectively, the conductance of the MOS transistors $Q_{12}$ becomes higher than that of the MOS transistor $Q_{14}$ so that the output voltage $V_{02}$ becomes low. As a result, the conductance of the MOS transistors $Q_{25}$ becomes small so that the reference voltage $V'_{R2}$ becomes high. Similarly, the output voltage $V_{01}$ becomes high and the reference voltage $V'_{R1}$ becomes low. As can be understood from Fig. 9, since the differences $\Delta V_{11}$, $\Delta V_{12}$ and $\Delta V_{21}$ in potential are much larger than $V_{th}$ whose value is, for example, 0.7 volt, the MOS transistors $Q_{12}$, $Q_{14}$ and $Q_{24}$ are conductive. Contrary to this, since the difference $\Delta V_{22}$ is smaller than $V_{th}$, the MOS transistor $Q_{22}$ is non-conductive.

Next, when the input voltage $V_{i1}$ is changed from high to low and the input voltage $V_{i2}$ is changed from low to high, the conductance of the MOS transistor $Q_{14}$ becomes higher than that of the MOS transistor $Q_{12}$ so that the output voltage $V_{02}$ becomes high. As a result, the conductance of the MOS transistors $Q_{25}$ becomes high so that the reference voltage $V'_{R2}$ becomes low. As a result, the MOS transistor $Q_{22}$ rapidly conducts, which invites the rapid decrease of the output voltage $V_{01}$. Similarly, the output voltage $V_{01}$ becomes low and the reference voltage $V'_{R1}$ becomes high so that the MOS transistor $Q_{12}$ rapidly cuts off, which invites the rapid increase of the output voltage $V_{02}$.

After that, as can be understood from Fig. 9, since the differences $\Delta V'_{11}$, $\Delta V'_{21}$ and $\Delta V'_{22}$ in potential are much larger than $V_{th}$, the MOS transistors $Q_{14}$, $Q_{22}$ and $Q_{24}$ are conductive. Contrary to this, since the difference $\Delta V'_{12}$ is smaller than $V_{th}$, the MOS transistor $Q_{12}$ is non-conductive. By using the sense amplifier circuit of Fig. 8, high and stable sensing speed whose value corresponds to $1/t_3$ in Fig. 9 can be obtained due to same reason as mentioned in the descriptions with regard to Fig. 5.

In addition, in Fig. 9, it should be noted that the difference of the voltage $V_{01}$ is the same as that of the voltage $V_{02}$ which is represented by $2V_d''$, since the transistors $Q_{12}$ and $Q_{22}$ are controlled on and off. (Note: in Fig. 5, the transistor $Q_{14}$ is always conductive.) Therefore, since the reference transistors $Q_{15}$ and $Q_{25}$ are also controlled by the output voltages $V_{01}$ and $V_{02}$, respectively, the difference $(=2V_d'')$ of the output voltages $V_{01}$ and $V_{02}$ is relatively large.

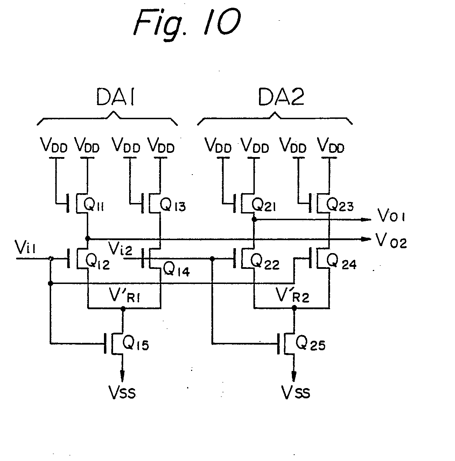

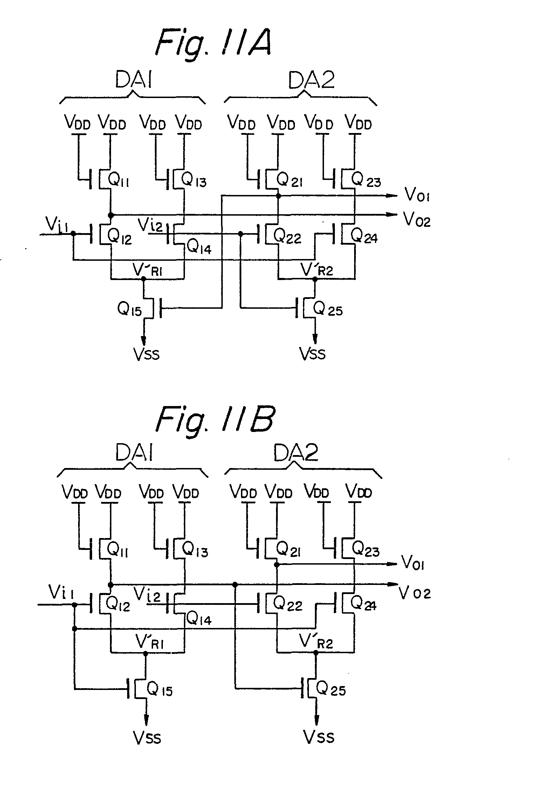

Figs. 10, 11A and 11B are circuit diagrams illustrating second, third and fourth embodiments of the sense amplifier circuit of the present invention. In Fig. 10, the reference MOS transistors $Q_{15}$ and $Q_{25}$ are controlled by the input voltages $V_{i1}$ and $V_{i2}$, respectively. In Fig. 11A, the reference MOS transistor $Q_{15}$ is controlled by the output voltage $V_{01}$ whose phase is the same as that of the input voltage $V_{i1}$ and the reference MOS transistor $Q_{25}$ is controlled by the input voltage $V_{i2}$. In Fig. 11B, the reference MOS transistor $Q_{15}$ is controlled by the input voltage $V_{i1}$ and the reference MOS transistor $Q_{25}$ is controlled by the output voltage $V_{02}$ whose phase is the same as that of the input voltage $V_{i2}$. The operations of these sense amplifier circuits of Figs. 10, 11A and 11B are similar to that of the sense amplifier circuit of Fig. 8.

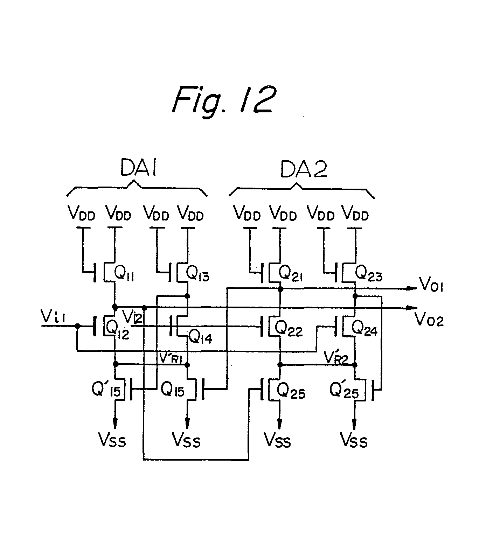

Fig. 12 is a circuit diagram illustrating a fifth embodiment of the sense amplifier circuit of the present invention. The sense amplifier circuit of Fig. 12 further comprises a reference MOS transistor $Q'_{15}$ connected in parallel to the reference MOS transistor $Q_{15}$ and a reference MOS transistor $Q'_{25}$ connected in parallel to the reference MOS transistor $Q_{25}$, in addition to the sense amplifier circuit of Fig. 8. The reference MOS transistor $Q'_{15}$ is controlled by an output voltage of the first differential amplifier whose phase is the same as that of the input voltage $V_{i1}$ and the reference MOS transistor $Q'_{25}$ is controlled by an output voltage of the second differential amplifier whose phase is the same as that of the input voltage $V_{i2}$. The operation of the sense amplifier circuit of Fig. 12 is similar to that of the sense amplifier circuit of Fig. 8. That is, when the voltage $V_{i1}$ is changed from high to low and the voltage $V_{i2}$ is changed from low to high, the gate voltage of the transistor $Q_{25}'$ begins to increase so that the conductance thereof increases. As a result, the reference voltage $V_{R2}'$ is decreased. Therefore, the gate-source voltage of the transistor $Q_{22}$ becomes large so as to decrease the output voltage $V_{01}$ rapidly. On the other hand, since the input voltage $V_{i1}$ is changed to low, the conductance of the transistor $Q_{12}$ is decreased so as to raise the output voltage $V_{02}$ which is applied to the transistor $Q_{25}$. Therefore, the conductance of the transistor $Q_{25}$ is increased, so that the reference voltage $V_{r2}'$ is more rapidly decreased. As a result, the conductance of the transistor $Q_{22}$ is increased so that the output voltage $V_{01}$ is more rapidly decreased. Similarly, the output voltage $V_{02}$ is rapidly increased. Thus, by providing the four reference transistors $Q_{15}$, $Q_{15}'$, $Q_{25}$ and $Q_{25}'$, one of the differential amplifiers begins to perform a sensing operation which decreases the reference voltage thereof. When the sensing operation is about to be completed, the differential amplifier receives a feedback by the other differential amplifier so that the reference voltage is more rapidly decreased. However, the former operation (Fig. 12) is more reliable than the latter operation (Fig. 8).

In Fig. 12, the reference MOS transistor $Q_{15}'$ and $Q_{25}'$ are controlled by the output voltages of the first and second differential amplifiers. However, it should be noted that the reference MOS transistors $Q_{15}'$ and $Q_{25}'$ can be controlled by the input voltages $V_{i1}$ and $V_{i2}$, respectively.

As explained hereinbefore, the sense amplifier circuit according to the present invention has the following advantages as compared with those of the prior art.

(1) High sensing speed can be obtained, since the conductances of the input transistors are forced to be large by controlling the corresponding reference transistors and the sensing operation is performed by one-stage amplification.

(2) Stable sensing operation can be obtained since the reference voltages of the differential amplifiers are variable, responsive to the changes of the input voltages which excludes the influence of the fluctuation of the power supply voltage.

## Claims

1. A sense amplifier circuit comprising first and second differential amplifiers (DA1, DA2) each of which consists of first and second input transistors ($Q_{12}$, $Q_{14}$, $Q_{24}$, $Q_{22}$), each input transistor being connected in series with a load transistor ($Q_{11}$, $Q_{13}$, $Q_{23}$, $Q_{21}$) which is connected to a first power supply line ($V_{DD}$), and a reference transistor ($Q_{15}$, $Q_{25}$) connected between the first and second input transistors ($Q_{12}$, $Q_{14}$, $Q_{24}$, $Q_{22}$) and a second power supply line ($V_{SS}$), the phases of first and second input signals ($V_{i1}$, $V_{i2}$) applied to the input transistors being mutually complementary, characterised in that the first input signal ($V_{i1}$) is connected to the gate electrodes of the first input transistors of the first and second differential amplifiers ($Q_{12}$, $Q_{24}$) and the second input signal is connected to the gate electrodes of the second input transistors of the first and second differential amplifiers ($Q_{14}$, $Q_{22}$, and the reference transistor of the first differential amplifier ($Q_{15}$ is controlled either by the first input signal ($V_{i1}$) or a first output signal provided by the second differential amplifier ($V_{01}$) which is in phase with the first input signal ($V_{i1}$), and the reference transistor of the second differential amplifier ($Q_{25}$) is controlled either by the second input signal ($V_{i2}$) or a first output signal provided by the first differential amplifier ($V_{02}$) which is in phase with the second input signal ($V_{i2}$).

2. A sense amplifier circuit according to claim 1, characterised by a third reference transistor ($Q_{15}'$) which is connected in parallel to the reference transistor ($Q_{15}$) of the first differential amplifier (DA1) and controlled either by the first input signal ($V_{i1}$) or by the second output signal of the first differential amplifier (DA1) the phase of which is inverse to that of the first output signal ($V_{02}$) of the first differential amplifier.

3. A sense amplifier circuit according to claim 1 or 2, characterised by a fourth reference transistor ($Q_{25}'$) which is connected in parallel to the reference transistor ($Q_{25}$) of the second differential amplifier (DA2) and controlled either by the second input signal ($V_{i2}$) or by the second output signal of the second differential amplifier (DA2) the phase of which is inverse to that of the first output signal ($V_{01}$) of the second differential amplifier (DA2).

## Patentansprüche

1. Leseverstärkerschaltung mit ersten und zweiten Differenzverstärkern (DA1, DA2), von denen jeder aus ersten und zweiten Eingangstransistoren ($Q_{12}$. $Q_{14}$, $Q_{24}$, $Q_{22}$) besteht, von denen jeder in Reihe mit einem Lastransistor ($Q_{11}$, $Q_{13}$, $Q_{23}$, $Q_{21}$) verbunden ist, der mit einer ersten Energieversorgungsleitung ($V_{DD}$) verbunden ist, und aus einem Referenztransistor ($Q_{15}$, $Q_{25}$), welcher zwischen den ersten und zweiten Eingangstransistoren ($Q_{12}$, $Q_{14}$, $Q_{24}$, $Q_{22}$) und einer zweiten Energieversorgungsleitung ($V_{SS}$) verbunden ist, wobei die Phasen der ersten und zweiten Eingangssignale ($V_{i1}$, $V_{i2}$), die den Eingangstransistoren zugeführt werden, wechselseitig komplementär zueinander sind, dadurch gekennzeichnet, daß das erste Eingangssignal ($V_{i1}$) den Gate-Elektroden der ersten Eingangstransistoren der ersten und der zweiten Differenzverstärker ($Q_{12}$, $Q_{24}$) und das zweite Eingangssignal den Gate-Elektroden der zweiten Eingangstransistoren der ersten und zweiten Differenzverstärker ($Q_{14}$, $Q_{22}$) zugeführt wird, und der Referenztransistor des ersten Differenzverstärkers ($Q_{15}$) entweder von dem ersten Eingangssignal ($V_{i1}$) oder einem ersten Ausgangssignal ($V_{01}$) gesteuert wird, welches von dem zweiten Differenzverstärker geliefert wird und mit dem ersten Eingangssignal ($V_{i1}$) in Phase ist, und daß der Referenztransistor des zweiten Differential-

verstärkers ($Q_{25}$) entweder von dem zweiten Eingangssignal ($V_{i2}$) oder einem ersten Ausgangssignal gesteuert wird, welches von dem ersten Differenzverstärker ($V_{02}$) geliefert wird und mit dem zweiten Eingangssignal ($V_{i2}$) in Phase ist.

2. Leseverstärkerschaltung nach Anspruch 1, gekennzeichnet durch einen dritten Referenztransistor ($Q'_{15}$), welcher parallel zu dem Referenztransistor ($Q_{15}$) des ersten Differentialverstärkers (DA1) angeschlossen ist und entweder durch das erste Eingangssignal ($V_{i1}$) oder durch das zweite Ausgangssignal des ersten Differentialverstärkers (DA1) gesteuert wird, dessen Phase invers zu derjenigen des ersten Ausgangssignals ($V_{02}$) des ersten Differenzverstärkers ist.

3. Leseverstärkerschaltung nach Anspruch 1 oder 2, gekennzeichnet durch einen vierten Referenztransistor ($Q'_{25}$), welcher parallel zu dem Referenztransistor ($Q_{25}$) des zweiten Differenzverstärkers (DA2) angeschlossen und entweder von dem zweiten Eingangssignal ($V_{i2}$) oder von dem zweiten Ausgangssignal des zweiten Differenzverstärkers (DA2) gesteuert wird, dessen Phase invers zu derjenigen des ersten Ausgangssignals ($V_{01}$) des zweiten Differenzverstärkers (DA2) ist.

**Revendications**

1. Circuit d'amplificateur de lecture comportant un premier et un second amplificateurs différentiels (DA1, DA2) comportant en un premier et un second transistors d'entrée (Q12, Q14, Q24, Q22), chaque transistor d'entrée étant connecté en série avec un transistor de charge (Q11, Q13, Q23, Q21) qui est connecté à une première ligne d'alimentation (VDD) et un transistor de référence (Q15, Q25) connecté entre le premier et le second transistors d'entrée (Q12, Q14, Q24, Q22) et une seconde ligne d'alimentation (VSS), les phases d'un premier et d'un second signaux d'entrée (Vi1, Vi2) appliqués aux transistors d'entrée étant mutuellement complémentaires, caractérisé en ce que le premier signal d'entrée (Vi1) est connecté aux électrodes de grille des premiers transistors d'entrée du premier et du second amplificateurs différentiels (Q12, Q24) et le second signal d'entrée est connecté aux électrodes de grille des seconds transistors d'entrée du premier et du second amplificateurs différentiels (Q14, Q22) et le transistor de référence du premier amplificateur préférentiel (Q15) est commandé par le premier signal d'entrée (Vi1) ou par un premier signal de sortie produit par le second amplificateur différentiel (V01) qui est en phase avec le premier signal d'entrée (Vi1), et le transistor de référence du second amplificateur différentiel (Q25) est commandé par le second signal d'entrée (Vi2) ou un premier signal de sortie produit par le premier amplificateur différentiel (V02) qui est en phase avec le second signal d'entrée (Vi2).

2. Circuit d'amplificateur de lecture selon la revendication 1, caractérisé par un troisième transistor de référence (Q'15) qui est connecté en parallèle avec le transistor de référence (Q15) du premier amplificateur différentiel (DA1) et commandé par le premier signal d'entrée (Vi1) ou par le second signal de sortie du premier amplificateur différentiel (DA1) dont la phase est inverse de celle du premier signal de sortie (V02) du premier amplificateur différentiel.

3. Circuit d'amplificateur de lecture selon la revendication 1 ou 2, caractérisé par un quatrième transistor de référence (Q'25) connecté en parallèle avec le transistor de référence (Q25) du second amplificateur différentiel (DA2) et commandé par le second signal d'entrée (Vi2) ou par le second signal de sortie du second amplificateur différentiel (DA2) dont la phase est inverse de celle du premier signal de sortie (V01) du second amplificateur différentiel (DA2).

Fig. 1

# Fig. 2

# Fig. 3

0 015 070

*Fig. 4*

*Fig. 5*

3

## Fig. 6

## Fig. 7

4

## Fig. 8

## Fig. 9

# Fig. 10

# *Fig. IIA*

# *Fig. IIB*

## Fig. 12